# EUROPEAN PATENT SPECIFICATION

(11) **EP 0 588 526 B1**
(45) Date of publication and mention of the grant of the patent: **15.04.1998**
(21) Application number: 93306876.9
(22) Date of filing: 31.08.1993
(51) Int. Cl.: H03H 21/00

(54) **A method of and system for noise suppression**
Verfahren und Einrichtung zur Störungsunterdrückung
Méthode et système pour supprimer du bruit

(30) Priority: 17.09.1992 FI 924174
(43) Date of publication of application: 23.03.1994
(73) Proprietor: NOKIA MOBILE PHONES LTD., 24101 Salo (FI)
(72) Inventor: Kolehmainen, Timo, SF-90560 Oulu (FI)
(74) Representative: Frain, Timothy John

(56) References cited:
- DE-A- 3 733 983
- 1988 IEEE MILITARY COMMUNIC. CONF. 23-26 OCT 1988; SAN DIEGO (US); P391-397; J.H. REED : A FREQUENCY DOMAIN TIME-DEPENDENT ADAPTIVE FILTER FOR INTERFERENCE REJECTION
- HEARING INSTRUMENTS vol. 37, no. 9 , September 1986 , DULUTH, MINNESOTA US pages 29 - 34 D.GRAUPE ET AL 'A SELF-ADAPTIVE NOISE FILTERING SYSTEM'

## Description

This invention relates to a method of and system for noise suppression in an analogue audio signal.

In an information channel, especially in telecommunication connections such as mobile telephone connections, there can be a significant level of noise. Noise can be caused both by the connection itself and by noise surrounding the actual signal source, i.e. the speaker. For example the background noise in a car can be transmitted in a radio telephone signal as noise in the background of the speech signal.

In audio communication systems, such as radio telephone systems, a purpose of acoustic noise suppression is to improve the quality of the audio signal by filtering the noise caused by the surrounding environment from the audio signal. Improving the quality of the audio signal by filtering the noise is especially important in an environment, where the background noise is unusually disturbing, like nearby an airport, in a car or in a noisy factory.

Several different methods can be used in suppressing interferences and noise. With a high pass filter placed before the telephone handset for example, the low frequency noise can be suppressed. In the signal coming from the exchange to a mobile telephone the noise is in the same frequency domain as the speech signal, so we are in a situation, in which the speech would be suppressed with the noise, if such a filter were used.

When speaking in a car efforts have been made to eliminate the impact of the background noise by, for example, using another microphone. This other microphone is placed so that it receives only background noise which can then be reduced from the entire signal before the speech signal is transmitted by the radio telephone. With this method only minor signal-to-noise ratio (SNR) improvements have been achieved, since the optimal positioning of the microphone is difficult.

Another prior art method for noise suppression is the so called spectral subtraction technique or spectral gain modification technique. This technique is based on dividing an audio input signal into individual spectral bands by a bank of filters, such as a bank of bandpass or all-pass filters and attenuating the spectral bands according to their noise energy content. Examples of the use of spectral subtraction techniques have been presented in U.S. Patent No. 4,628,529 and in U.S. Patent Application US-A-349,160 (corresponds to patent FI 80,173). A noise suppression filter based on spectral subtraction technique produces an estimate of the spectral density of the power of the background noise, on the basis of which it determines a signal-to-noise ratio (SNR) for the speech in each channel. This ratio is used in calculating amplification coefficients for each channel. Based on the amplification coefficient an attenuation is determined separately for each channel, according to which the channels are attenuated and finally the channels are summed up to produce a noise suppressed output signal.

In difficult conditions, when background noise is especially disturbing, performance limitations appear in most noise suppression techniques and systems. Normally with systems based on spectral noise subtraction background noise can, in audio frequencies, be reduced by as much as 10 dB without seriously affecting the speech quality. However, the speech quality degrades when the noise requires 20 dB suppression. Noise flutter appears in systems based on spectral noise subtraction since the individual channel gain parameters are continuously being updated as background noise changes. An additional problem in spectral subtraction noise suppression systems is the attenuation of narrowband noise. High energy narrowband noise usually appears only in few channels and therefore it cannot be attenuated with systems attenuating the background noise. Since spectral noise suppression is based on dividing the frequency band into several narrow bands, channels, from which noise is suppressed and which are combined after attenuation to form an output signal, interference appears in band divisions and above mentioned noise flutter is generated to the band borders.

DE 3733983 discloses a method of damping interference noise in sound transmitted by a hearing aid. The method is based on digitising the detected sound signals, determining their spectral distributions, monitoring them in a number of frequency windows and comparing them with preassigned threshold values.

The invention is defined by the appended claims.

According to a first aspect of the present invention there is provided a method of noise suppression in an analog audio signal, comprising:
sampling an analogue audio signal with an A/D converter, to produce a sampled digital signal; and
subtracting the noise spectrum from the sampled digital signal with a digital spectral filter realizing an inverted noise spectrum of the input signal in substantially the entire frequency domain of the input signal,
characterised in that the method further comprises smoothing parameters of the filter by keeping the updating frequency of the parameters low when the noise spectrum is alternating rapidly.

According to a second aspect of the present invention there is provided a system for noise suppression in an analogue audio signal, comprising:
an A/D converter for sampling the analogue audio signal to produce a sampled digital signal; and
a digital spectral filter realizing an inverted noise spectrum of the input signal in substantially the entire frequency domain of the input signal for suppressing the noise from the sampled digital signal;
characterised in that the system further comprises decision and smoothing means (7) for making a decision on updating the filter parameters (15) on the basis of binary digits (13) received from a detector (3), for smoothing the parameters (15) by keeping the updating frequency of the parameters low when the noise spectrum is alternating rapidly and for transferring the parameters (15) to the filter (4).

An advantage of the present invention is the provision of a method of and system for noise suppression in high background noise environments without significantly impairing the speech quality, and with which narrowband noise bursts can be eliminated, the appearance of noise fluctuations and sudden background noise increases can be avoided.

Noise may be suppressed from an audio signal with a spectral filter, the frequency band of which covers the audio frequencies, preferably the speech frequencies 500 Hz - 4 kHz. The filter accomplishes in the frequency domain of the input signal an inverted noise spectrum, which is estimated when speech is not present. The frequency response of the filter is updated continuously. By updating the parameters of the spectral filter at controlled intervals and smoothing (averaging) them, the noise flutter can be eliminated at low frequencies.

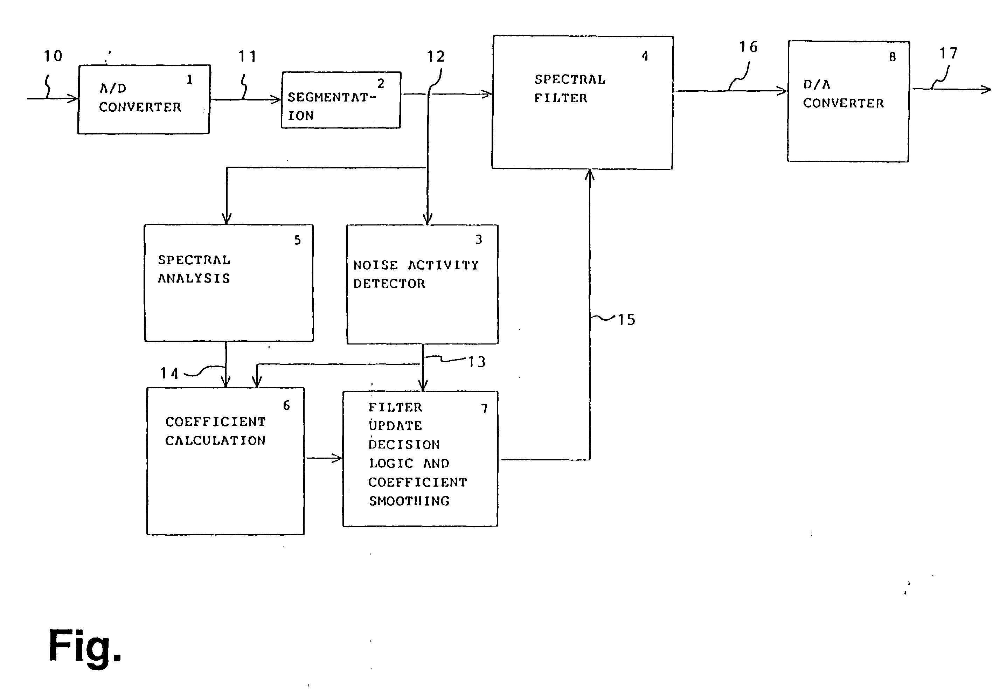

An embodiment of the present invention will now be described in more detail, by way of example, with reference to the accompanying drawing, which shows a system capable of utilizing the method of the present invention.

The figure shows a noise suppression system in accordance with the present invention for suppressing background noise in high background noise environments without significantly impairing the speech quality. An analogue speech signal 10 is first sampled with an A/D converter 1. The sampling frequency is determined by the frequency band of the input signal. The digitised samples 11 produced by the A/D converter 1 are divided into frames in a segmentation block 2, where each frame has N samples and forms a speech frame, where N is a positive integer. The segmented samples 12 produced as output are fed to a spectral analysis block 5, which calculates a group of coefficients 14 for each frame. The coefficients 14 from the spectral analysis block 5 depend on the kind of analysis used. The spectral analysis can be accomplished with a Fast Fourier Transformation (FFT) with a high number of coefficients or with a simple Linear Prediction Coding (LPC) analysis.

The calculated coefficients 14 are fed into a coefficient calculation block 6, which calculates the coefficients of a spectral filter 4 on the basis of coefficients 14 received from the spectral analysis block 5. The coefficient calculation block 6 modifies the coefficients 14 received from the spectral analysis block 5 to a proper form for the spectral filter 4 i.e. forms the parameters of the spectral filter.

The system comprises a noise activity detector 3, which produces a binary digit 13 on the basis of the segmented samples 12 depending on whether the frame contains speech or background noise. The filter update decision logic and coefficient smoothing block 7 decides on the basis of the binary digit 13 received from the noise activity detector 3, whether it updates the filter parameters 15 with the new coefficients calculated by the coefficient calculation block 6 or not. The filter parameters are updated for example only when the input signal 10 includes only noise.

The updating of the filter parameters only when the input signal 10 includes only noise is one alternative. Then it is presumed that there are pauses in the speech, like in a normal phone conversation, and in addition it is presumed that the noise spectrum remains somewhat constant during a speech period, which is true when driving in a car at an even velocity. If the filter parameters are not updated during the speech, harmful effects due to the altering of the filter frequency response are naturally left out. In conditions where the noise spectrum alternates rapidly at the same time when it is desired to transmit speech, it is advantageous to update parameters also during the speech.

Block 7 can thus change the adaptation of the parameters of the filter 4 with the help of the binary digit 13. Block 7 learns the noise spectrum for each transmission during a speech pause (and if desired attenuates the background noise substantially completely during a speech pause). The separation of the speech spectrum and the noise spectrum from each other is not entirely possible during speech, since block 5 estimates the speech and the noise spectrum together. Anyway block 7 knows what the noise spectrum was right before the speech commenced. Block 7 utilizes this information and the information of the combined spectrum of speech and noise outputted by blocks 5 and 6 so that during a clearly formantic speech frame it attenuates the formantic areas less than the areas between the formants, taking however the basic format of the noise spectrum into consideration.

Therefore the noise spectrum is properly weighted by the formantic spectrum and the presumption then is that the level of the speech signal is considerably above the noise level (not considering extremely noisy environments). If the speech frame is not formantic, but the spectrum is more even, the estimated noise spectrum is used directly. However, the advantage in regard to the filter bank methods is that there are no separate signal bands, but the filtering is performed in the whole frequency band.

Block 7 smooths (averages) the filter parameters 15 as the background noise spectrum is alternating rapidly. By smoothing and controlling the updating speed of the parameters the low frequency noise flutter is eliminated. With block 7 the extent of the smoothing can be controlled. In conditions where the background spectrum alternates rapidly, the updating frequency of the spectral filter 4 parameters 15 is kept low in order to avoid generation of noise flutter.

The spectral filter parameters are fed to the spectral filter 4, which functions as an inverted noise filter, that is, as a filter which has an inverted frequency response compared to the noise spectrum, whereby the background noise spectrum can be effectively subtracted from the speech and noise spectrum of the input signal. The output signal 16 of the filter 4, a substantially noiseless speech spectrum, is converted to an analogue speech signal 17 with a D/A converter 8.

With a method and system in accordance with the present invention the noise is filtered in the frequency domain and the filtration depth can be controlled. Therefore the frequency spectrum can be modified and such parts of the spectrum which do not have formantic energy can be filtered out. The spectral filter 4 of the noise suppression system can be realized with IIR- or FIR-filters or with a combinations of these, which can be realized with the help of a processor or processors. The realization of a digital filter is known as such to a person skilled in art, and therefore it is not presented in the context of this invention. According to the noise suppression requirements a filter meeting the necessary requirements can be realized. The accuracy of the noise filtration can be controlled with the spectral analysis block 5, the accuracy of which is affected by the analysis method used.

With the present invention the band border interferences are avoided since the entire frequency band is filtered as a whole. Due to smooth spectral filtering the voice quality is better than in prior known methods. The realization of the invention does not much increase the costs in digital phones, since in the method the speech spectrum used for noise suppression is acquired with linear predictive coding which is performed anyway and the noise spectrum is acquired with the noise activity detector 3 and thus not a great amount of additional logic is needed for producing these spectrums.

In view of the foregoing it will be clear to a person skilled in the art that modifications may be incorporated without departing from the scope of the present invention.

## Claims

1. A method of noise suppression in an analog audio signal (10), comprising:
sampling an analogue audio signal (10) with an A/D converter (1), to produce a sampled digital signal (11,12); and
subtracting the noise spectrum from the sampled digital signal (11, 12) with a digital spectral filter (4) realizing an inverted noise spectrum of the input signal (10) in substantially the entire frequency domain of the input signal (10),
characterised in that the method further comprises smoothing parameters of the filter (4) by keeping the updating frequency of the parameters low when the noise spectrum is alternating rapidly.

2. A method as claimed in claim 1, further comprising dividing the digitised samples (11) produced by the A/D converter (1) into frames (12) containing N samples, where N is a positive integer prior to the subtraction step.

3. A method as claimed in claim 1 or 2, further comprising calculating a group of coefficients (14) from the samples (11, 12) using spectral analysis techniques, and on the basis of these coefficients (14) forming the parameters (15) for the spectral filter (4).

4. A method as claimed in claim 3, wherein the spectral analysis is accomplished by Fast Fourier Transformation (FFT) or by Linear Prediction Coding (LPC) analysis.

5. A method as claimed in any previous claim, further comprising determining whether the samples (11, 12) contain speech or noise.

6. A method as claimed in claim 5, comprising deciding whether the filter parameters are updated with the new parameters on the basis of the determination.

7. A method as claimed in claim 6, wherein the filter parameters are updated, when on the basis of the determination it is verified that the input signal (10) includes substantially only noise.

8. A method as claimed in any of claims 1 to 4, wherein the filter (4) parameters are updated substantially continuously.

9. A system for noise suppression in an analogue audio signal, comprising:
an A/D converter (1) for sampling the analogue audio signal to produce a sampled digital signal (11,12); and
a digital spectral filter (4) realizing an inverted noise spectrum of the input signal (10) in substantially the entire frequency domain of the input signal (10) for suppressing the noise from the sampled digital signal (11, 12);
characterised in that the system further comprises decision and smoothing means (7) for making a decision on updating the filter parameters (15) on the basis of binary digits (13) received from a detector (3), for smoothing the parameters (15) by keeping the updating frequency of the parameters low when the noise spectrum is alternating rapidly and for transferring the parameters (15) to the filter (4).

10. A system as claimed in claim 9, further comprising a Digital to Analogue converter to convert the digital noise suppressed output signal (16) into an analogue noise suppressed speech signal (17).

## Patentansprüche

1. Verfahren zur Unterdrückung von in einem analogen Audiosignal (10) enthaltenem Rauschen, mit folgenden Schritten:
Abtasten des analogen Audiosignals (10) mit einem A/D Wandler (1) zur Erzeugung eines digitalen Signals (11,12); und
Subtraktion des Rauschspektrums von dem durch Abtastung erhaltenen digitalen Signal (11,12) mit Hilfe eines digitalen Spektralfilters (4), das im wesentlichen über den gesamten Frequenzbereich des Eingangssignals (10) ein invertiertes Rauschspektrum des Eingangssignals (10) liefert, **dadurch gekennzeichnet**, daß ferner eine Glättung von Parametern des Filters (4) erfolgt, indem bei einer schnellen Änderung des Rauschspektrums die Aktualisierungsfrequenz der Parameter niedrig gehalten wird.

2. Verfahren nach Anspruch 1 zur Teilung der vom A/D Wandler (1) erzeugten digitalisierten Abtastwerte (11) in N Abtastwerte enthaltende Rahmen (12), wobei N vor dem Subtraktionsschritt positiv ganzzahlig ist.

3. Verfahren nach Anspruch 1 oder 2 zur Berechnung einer Gruppe von Koeffizienten (14) aus den Abtastwerten (11,12) unter Verwendung spektraler Analysetechniken, um aufgrund dieser Koeffizienten (14) die Parameter (15) für das spektrale Filter (4) zu bilden.

4. Verfahren nach Anspruch 3, bei dem die Spektralanalyse mittels Fast Fourier Transformation (FFT) oder linearer Vorhersagecodeanalyse (LPC) erfolgt.

5. Verfahren nach irgendeinem der vorangegangenen Ansprüche, bei dem bestimmt wird, ob die Abtastwerte (11, 12) Sprache oder Rauschen enthalten.

6. Verfahren nach Anspruch 5 zur Entscheidung, ob aufgrund der Bestimmung die Filterparameter mit den neuen Parametern aktualisiert werden.

7. Verfahren nach Anspruch 6, bei dem die Filterparameter aktualisiert werden, wenn aufgrund der Bestimmung verifiziert ist, daß das Eingangssignal (10) im wesentlichen nur Rauschen enthält.

8. Verfahren nach irgendeinem der Ansprüche 1 bis 4, bei dem die Parameter des Filters (4) im wesentlichen kontinuierlich aktualisiert werden.

9. System zur Unterdrückung von in einem analogen Audiosignal enthaltenem Rauschen, mit:
einem A/D Wandler (1) zur Abtastung des analogen Audiosignals, um ein digitales Signal (11,12) zu erzeugen; und
einem digitalen Spektralfilter (4) zur Lieferung eines im wesentlichen über den gesamten Frequenzbereich des Eingangssignals (10) invertierten Rauschspektrums des Eingangssignals (10), um das im digitalen Signal (11, 12) enthaltene Rauschen zu unterdrücken, **dadurch gekennzeichnet**, daß das System ferner Entscheidungs- und Glättungsmittel (7) enthält, um aufgrund von von einem Detektor (3) empfangenen Binärziffern (13) eine Entscheidung bezüglich der Aktualisierung der Filterparameter (15) zu treffen, um die Parameter (15) zu glätten, indem bei einer schnellen Änderung des Rauschspektrums die Aktualislerungsfrequenz der Parameter niedrig gehalten wird, und um die Parameter (15) an das Filter (4) zu übertragen.

10. System nach Anspruch 9, mit einem D/A-Wandler zur Wandlung des digitalen, rauschunterdrückten Ausgangssignals (16) in ein analoges, rauschunterdrücktes Sprachsignal (17).

## Revendications

1. Procédé de suppression du bruit dans un signal audio analogique (10), comprenant :
l'échantillonnage d'un signal audio analogique (10) avec un convertisseur A/N (1), afin d'obtenir un signal numérique échantillonné (11, 12) ; et
la soustraction du spectre de bruit du signal numérique échantillonné (11, 12) avec un filtre spectral numérique (4) réalisant un spectre de bruit inversé du signal d'entrée (10) dans le domaine pratiquement entier de fréquence du signal d'entrée (10),
caractérisé en ce que le procédé comporte en outre le lissage des paramètres du filtre (4) en maintenant à une faible valeur la fréquence de mise à jour des paramètres lorsque le spectre de bruit alterne rapidement.

2. Procédé selon la revendication 1, comprenant en outre la division des échantillons numérisés (11) produits par le convertisseur A/N (1) en trames (12) contenant N échantillons, où N est un nombre entier positif avant l'étape de soustraction.

3. Procédé selon la revendication 1 ou 2, comprenant en outre le calcul d'un groupe de coefficients (14) à partir des échantillons (11), 12) en utilisant des techniques d'analyse spectrale, et sur la base de ces coefficients (14) la formation des paramètres (15) pour le filtre spectral (4).

4. Procédé selon la revendication 3, dans lequel l'analyse spectrale est effectuée par une transformation accélérée de Fourier (FTT) ou par une analyse de codage à prédiction linéaire (LPC).

5. Procédé selon l'une quelconque des revendications précédentes, comprenant en outre la détermination du fait que les échantillons (11, 12) contiennent ou non la parole ou un bruit.

6. Procédé selon la revendication 5, comprenant le fait de décider si oui ou non les paramètres du filtre sont mis à jour avec les nouveaux paramètres sur la base de la détermination.

7. Procédé selon la revendication 6, dans lequel les paramètres du filtre sont mis à jour, lorsque, sur la base de la détermination, il est vérifié que le signal d'entrée (10) ne comprend pratiquement que du bruit.

8. Procédé selon l'une quelconque des revendications 1 à 4, dans lequel les paramètres du filtre (4) sont mis à jour d'une façon sensiblement continue.

9. Système pour la suppression du bruit dans un signal audio analogique, comprenant :
un convertisseur A/N (1) pour échantillonner le signal audio analogique et produire un signal numérique échantillonné (11, 12); et
un filtre spectral numérique (4) réalisant un spectre de bruit inversé du signal d'entrée (10) dans pratiquement la totalité du domaine fréquence du signal d'entrée (10) afin de supprimer le bruit du signal numérique échantillonné (11, 12);
caractérisé en ce que le système comprend en outre un moyen de décision et de lissage (7) pour prendre une décision sur la mise à jour des paramètres (15) du filtre sur la base de chiffres binaires (13) reçus en provenance d'un détecteur (3), afin de lisser les paramètres (15) en maintenant à une faible valeur la fréquence de mise à jour des paramètres lorsque le spectre de bruit alterne rapidement et afin de transférer les paramètres (15) au filtre (4).

10. Système selon la revendication 9, comprenant en outre un convertisseur numérique vers analogique pour convertir le signal de sortie numérique au bruit supprimé (16) en un signal de la parole analogique au bruit supprimé (17).
